# EUROPEAN PATENT APPLICATION

(11) **EP 3 312 496 A1**
(43) Date of publication of application: **25.04.2018**
(21) Application number: 16776698.9
(22) Date of filing: 08.04.2016
(51) Int. Cl.: F21K 9/68, F21S 2/00, F21V 7/00, F21Y 115/10

(54) **LIGHT-EMITTING DIODE TYPE LIGHTING DEVICE**

(30) Priority: 10.04.2015 JP 2015080787; 28.04.2015 JP 2015091148; 02.07.2015 JP 2015133423; 06.09.2015 JP 2015197997; 07.09.2015 JP 2015190395; 01.12.2015 JP 2015246720; 03.12.2015 JP 2015247951
(71) Applicant: Abram Corporation, Tokyo 102-0093 (JP)
(72) Inventor: MITSUZUKA, Hidetoshi, Tokyo 102-0093 (JP); KOJIMA, Yujiro, Tokyo 102-0093 (JP); KURIHARA, Kenichi, Tokyo 102-0093 (JP); KOJIMA, Kazunori, Tokyo 102-0093 (JP)
(74) Representative: Gevers Patents
(86) International application number: PCT/JP2016/061598
(87) International publication number: WO 2016/163532

(57) **Abstract**

An LED lighting device includes a light reflective member. The light reflective member is provided to extend so as to cause light emitted from an LED element to have light directivity and to radiate from an LED lighting tube to the outside of the tube. The reflective member includes a light directivity forming surface and a pseudo LED element forming surface. The light directivity forming surface causes the light emitted from the LED element to have the light directivity and to be directed from the LED lighting tube toward the outside of the tube. The pseudo LED element forming surface reflects a pseudo LED element of the LED element installed on the substrate. The light radiated from the LED element is radiated to the outside of the tube after having been confined in the tube.

## Description

### Technical Field

The present invention relates to a light-emitting diode type lighting device having characteristics in structures of heat radiation and reflection, and more particularly, to a straight-tube light-emitting diode type lighting device.

### Background Art

A semiconductor element emits light upon the application of voltage, which is the principle of light emission of an LED. It is widely known that the element is installed on a substrate and energized, but a heat sink is necessary for radiating heat generated when the LED element is energized.

In comparison with conventional lighting fixtures, the LED can provide the same level of illuminance and light energy as that of conventional incandescent lamps and fluorescent lamps while reducing power consumption. Thus, a wider spread of the LED is promising in the future. Particularly, a straight LED lighting tube that has the same exterior appearance as that of a fluorescent lamp and can also be attached to existing fluorescent lamp fixtures without any change is a typical LED light source as an alternative light source of the fluorescent lamp.

In general, LED lighting tubes fall into two broad categories: general lighting purpose and plant cultivation purpose. For each purpose, the LED lighting tube is a cylindrical tube that includes a light-emitting surface made of translucent or transparent glass or synthetic resin and a heat sink for radiating heat of an LED substrate. In the tube body, LED elements are installed on one surface at predetermined intervals and a circuit substrate that allows current to pass therethrough is provided.

The LED lighting tube as a whole has the same shape as that of a straight-tube fluorescent lamp, and includes caps mounted on both sides of the tube body and terminals formed to protrude for connection to fixtures. Such a structure described above allows the LED lighting tube to be attached to existing fluorescent lamp fixtures without saying newly provided fluorescent lamp fixtures. The LED lighting tube receives power supply from the fluorescent lamp fixtures and allows the LED in the tube to emit light.

As the invention related to such a straight LED lighting tube, Patent Document 1, for example, discloses an LED lighting tube that includes a cylindrical tube body made of polycarbonate, a heat sink made of aluminum mounted on an opening partially provided around the tube body, and a plurality of LEDs installed in the tube body.

Patent Document 2 discloses an LED lighting tube having an annular structure in which a translucent casing and a radiating plate that includes a holding portion coupled to this casing create an internal hollow. The LED lighting tube includes a circuit substrate fixed to the holding portion of the radiating plate so as to have thermal conductivity, one or more LED light sources attached to the circuit substrate, and two end caps inserted suitably at two end portions of the tubular structure. In Patent Document 2, the LED lighting tube can be attached to fluorescent lamp fixtures and used instead of conventional fluorescent lamps, and the LED lighting tube can radiate light uniformly.

### Citation List

### Patent Documents

Patent Document 1: Japanese Patent Application Laid-Open No. 2011-113876
Patent Document 2: Japanese Patent Application Laid-Open No. 2013-219004

### Summary of Invention

### Technical Problem

The present invention has been made in view of the conventional faults, and an object thereof is to provide a light-emitting diode type lighting device that radiates light emitted from an LED element as a light source, the light having a wide radiation angle of 160 degrees to 180 degrees and high illuminance (total luminous flux).

### Solution to Problem

A light-emitting diode type lighting device includes: an LED lighting tube that includes a total luminous flux transparent plate arranged in a light radiation direction; an LED element disposed on a substrate in the LED lighting tube so as to face the total luminous flux transparent plate; and a light reflective member including a converging reflective surface that is arranged on a side from which the LED element emits light and has light reflective characteristics. The light reflective member is arranged so as to extend in the light radiation direction symmetrically or asymmetrically with respect to a central line of the LED element. The converging reflective surface of the light reflective member includes: a light directivity forming surface that causes light emitted from the LED element to have light directivity and to radiate from the LED lighting tube to the outside of the tube through the total luminous flux transparent plate; and a light confining means for confining the light emitted from the LED element in the total luminous flux transparent plate and/or a space between the total luminous flux transparent plate and the light reflective member, the light then being radiated to the outside of the tube through the total luminous flux transparent plate.

A light-emitting diode type lighting device includes: an LED lighting tube that includes a total luminous flux transparent plate arranged in a light radiation direction; an LED element disposed on a substrate in the LED lighting tube so as to face the total luminous flux transparent plate; and a light reflective member including a converging reflective surface that is arranged on a side from which the LED element emits light and has light reflective characteristics. The light reflective member is arranged so as to extend in the light radiation direction symmetrically or asymmetrically with respect to a central line of the LED element. The converging reflective surface of the light reflective member includes: a light directivity forming surface that causes light emitted from the LED element to have light directivity and to radiate from the LED lighting tube to the outside of the tube through the total luminous flux transparent plate, and a pseudo LED element forming surface that reflects a pseudo LED element of the LED element. The pseudo LED element of the LED element arranged on the substrate is reflected on the pseudo LED element forming surface when the LED element is seen from a direction of the light radiated from the LED element arranged on the substrate.

A light-emitting diode type lighting device includes: an LED lighting tube that includes a total luminous flux transparent plate arranged in a light radiation direction; an LED element disposed on a substrate in the LED lighting tube so as to face the total luminous flux transparent plate; and a light reflective member including a converging reflective surface that is arranged on a side from which the LED element emits light and has light reflective characteristics. The light reflective member includes a first light reflective member and a second light reflective member. The first light reflective member includes the converging reflective surface that is arranged on the side from which the LED element emits light and has the light reflective characteristics. The first light reflective member is arranged so as to extend in the light radiation direction symmetrically or asymmetrically with respect to a central line of the LED element. The converging reflective surface of the first light reflective member includes: a light directivity forming surface that causes light emitted from the LED element to have light directivity and to radiate from the LED lighting tube to the outside of the tube through the total luminous flux transparent plate; and a pseudo LED element forming surface that reflects a pseudo LED element of the LED element. The second light reflective member including a converging light reflective surface that is arranged to face the total luminous flux transparent plate in the lighting tube and has light reflective characteristics is provided. The second light reflective member is arranged outward in a wide-angle direction from the end of the first light reflective member along the shape of the total luminous flux transparent plate. The second light reflective member includes a light confining means for confining the light emitted from the LED element in the total luminous flux transparent plate and/or a space between the total luminous flux transparent plate and the light reflective member, the light then being radiated to the outside of the tube through the total luminous flux transparent plate. The pseudo LED element installed on the substrate is reflected on the pseudo LED element forming surface when the light is radiated to the outside of the lighting tube.

A light-emitting diode type lighting device includes: an LED lighting tube that includes a total luminous flux transparent plate arranged in a light radiation direction; an LED element disposed on a substrate in the LED lighting tube so as to face the total luminous flux transparent plate; and a light reflective member including a converging reflective surface that is arranged on a side from which the LED element emits light and has light reflective characteristics. The light reflective member includes a first light reflective member and a second light reflective member. The first light reflective member includes the converging reflective surface that is arranged on the side from which the LED element emits light and has the light reflective characteristics. The first light reflective member is arranged so as to extend in the light radiation direction symmetrically or asymmetrically with respect to a central line of the LED element. The converging reflective surface of the first light reflective member includes: a light directivity forming surface that causes light emitted from the LED element to have light directivity and to radiate from the LED lighting tube to the outside of the tube through the total luminous flux transparent plate; and a pseudo LED element forming surface that reflects a pseudo LED element of the LED element. The second light reflective member including a light reflective surface that is arranged to face the total luminous flux transparent plate in the lighting tube and has light reflective characteristics is provided. The second light reflective member is arranged outward in a wide-angle direction from the end of the first light reflective member along the shape of the total luminous flux transparent plate. The second light reflective member includes a light confining means for confining the light emitted from the LED element in the total luminous flux transparent plate and/or a space between the total luminous flux transparent plate and the reflective member, the light then being radiated to the outside of the tube through the total luminous flux transparent plate. The pseudo LED element of the LED element arranged on the substrate is reflected on the pseudo LED forming surface when the LED element is seen from a direction of the light radiated from the LED element arranged on the substrate.

The light-emitting diode type lighting device is arranged in a position that does not interfere with the light emitted from the LED element.

The cylindrical tube body includes a locking portion for locking the light reflective member.

The light reflective member is made of a resin member.

A third light reflective member that connects the first light reflective member and the second light reflective member is provided.

The pseudo LED element forming surface is formed to be defined by a total reflectance of the first light reflective member, an angle of elevation of the first light reflective member, and an interval between an arrangement end of the LED element and the first light reflective member.

The first light reflective plate has an angle of elevation set from 50 degrees to 75 degrees with respect to the substrate.

A length of an interval between an arrangement end of the LED element and the converging reflective surface of the light reflective member is set from 0.1 mm to 5.0 mm, an angle of elevation of the substrate surface is set from 50 degrees to 75 degrees, and a height of the first light reflective member is five or more times as large as a width of the LED element and is preferably set to 10 mm to 20 mm.

At least one of a total reflectance of the light reflective surface, an angle of elevation of the first light reflective member, and a length of an interval between an arrangement end of the LED element and the converging reflective surface of the reflective member is changed to change the number of the pseudo LED elements reflected on the pseudo LED element forming surface to project the pseudo LED element forming surface.

The second reflective member and/or the total luminous flux transparent plate has a recessed portion for confining light.

The total luminous flux transparent plate has a total luminous flux transmittance of greater than or equal to 95%.

A total reflectance of the light reflective member is defined by greater than or equal to 80%.

The light reflective surface of the first light reflective member includes the light directivity forming surface and the pseudo LED element forming surface having different total reflectances and/or shapes.

The second light reflective member includes a heat sink.

The light-emitting diode type lighting device is a straight-tube light-emitting diode type lighting device.

An electronic device includes the light-emitting diode type lighting device.

A plant factory includes the light-emitting diode type lighting device.

An LED sign includes the light-emitting diode type lighting device. Advantageous Effects of Invention

The present invention provides a light-emitting diode type lighting device that radiates light emitted from an LED element, the light having a wide radiation angle of 160 degrees to 180 degrees and high illuminance (total luminous flux).

### Brief Description of Drawings

Fig. 1 is a perspective view of a straight-tube light-emitting diode type lighting device according to this embodiment.
Fig. 2 is an exploded perspective view of the straight-tube light-emitting diode type lighting device illustrated in Fig. 1.
Fig. 3 is a cross-sectional view of the straight-tube light-emitting diode type lighting device according to the first embodiment taken along an A-A section line illustrated in Fig. 1.
Fig. 4 is a schematic view for explaining an optical path of light emitted from a light source, which is an LED element, in the light-emitting diode type lighting device in Fig. 1.
Fig. 5A shows a picture in which the light emitted from the LED element is radiated from a lighting tube via a total luminous flux transparent plate from a state of having been confined. Fig. 5B shows a picture in which the light emitted from the LED element is radiated from a state of not having been confined.
Fig. 6 shows a picture in which a pseudo LED element of the LED element installed on a substrate is reflected on a pseudo LED element forming surface of a first light reflective member.
Fig. 7 is a cross-sectional view of the straight-tube light-emitting diode type lighting device in which a locking portion is provided on a tube body member.
Fig. 8 is a cross-sectional view of a straight-tube light-emitting diode type lighting device according to a second embodiment taken along the A-A section line illustrated in Fig. 1.
Fig. 9 is a cross-sectional view of a straight-tube light-emitting diode type lighting device according to a third embodiment taken along the A-A section line illustrated in Fig. 1.
Fig. 10 is a cross-sectional view of a straight-tube light-emitting diode type lighting device according to a fourth embodiment taken along the A-A section line illustrated in Fig. 1.
Fig. 11 is a cross-sectional view of a straight-tube light-emitting diode type lighting device according to a fifth embodiment taken along the A-A section line illustrated in Fig. 1.
Fig. 12 is a cross-sectional view of a straight-tube light-emitting diode type lighting device including a built-in power source.
Fig. 13 is a diagram for explaining another arrangement example of LED elements according to an embodiment of the present invention.
Fig. 14 is a diagram for explaining still another arrangement example of the LED element according to the embodiment of the present invention.

### Description of Embodiments

### First Embodiment

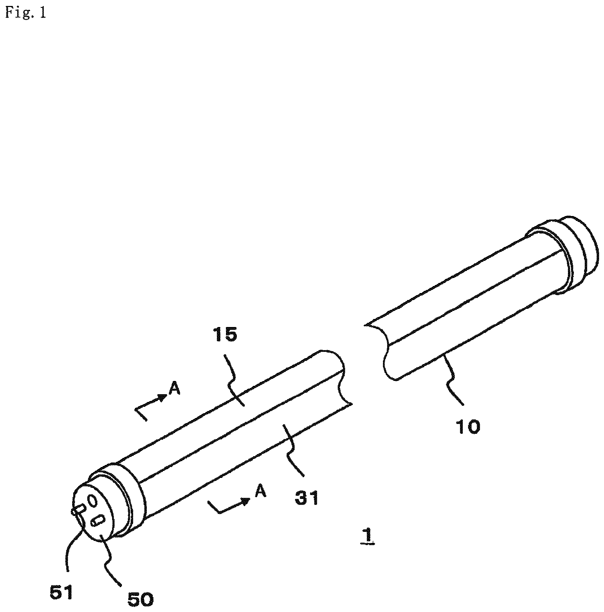

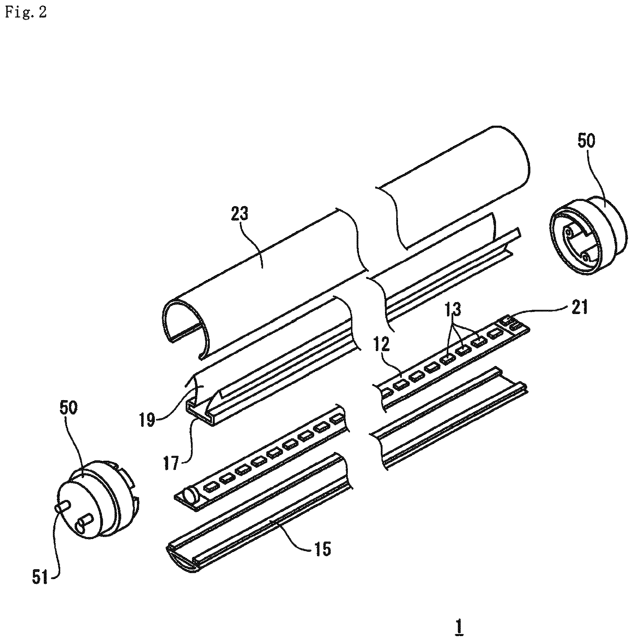

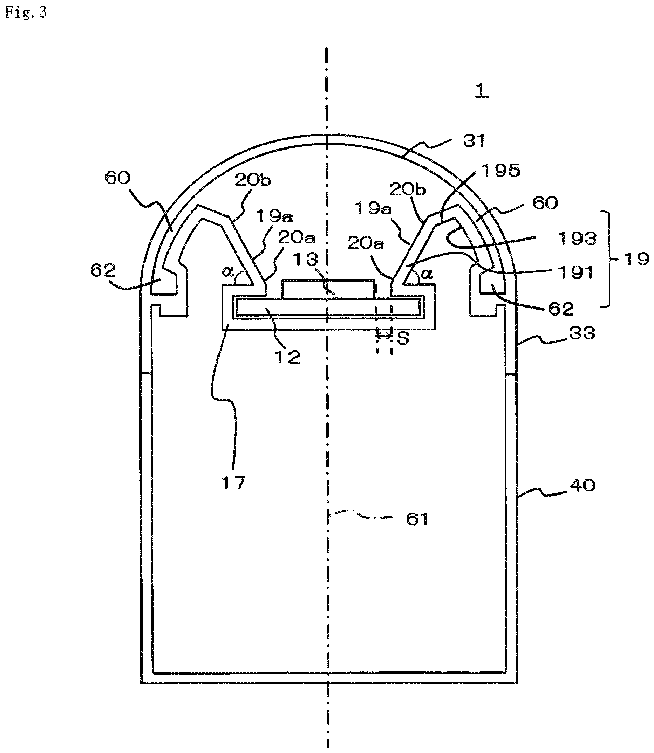

Hereinafter, a light-emitting diode type lighting device, particularly, a straight-tube light-emitting diode type lighting device according to the present invention is described in detail. Fig. 1 is a schematic view of a light-emitting diode type lighting device according to the present invention. Fig. 2 is an exploded perspective view of the straight-tube light-emitting diode type lighting device illustrated in Fig. 1. Fig. 3 is a cross-sectional view of the straight-tube light-emitting diode type lighting device according to the first embodiment taken along an A-A section line illustrated in Fig. 1.

In Fig. 3, a light-emitting diode type lighting device preferably includes: an LED lighting tube that includes a total luminous flux transparent plate arranged in a light radiation direction; an LED element as a light source disposed on a substrate in the LED lighting tube so as to face the total luminous flux transparent plate; and a first light reflective member including a converging reflective surface that is arranged on a side from which the LED element emits light and has light reflective characteristics. The first light reflective member is arranged so as to extend in the light radiation direction symmetrically or asymmetrically with respect to a central line of the LED element. The converging reflective surface of the first light reflective member includes: a light directivity forming surface that causes light emitted from the LED element to have light directivity and to radiate from the LED lighting tube to the outside of the tube through the total luminous flux transparent plate; and a pseudo LED element forming surface that reflects a pseudo LED element of the LED element. A second light reflective member that is arranged to face the total luminous flux transparent plate in the lighting tube and has light reflective characteristics is provided. The second light reflective member is arranged outward in a wide-angle direction from the end of the first light reflective member along the shape of the total luminous flux transparent plate.

A first light reflective member 191 is arranged at both sides of an LED element symmetrically with respect to a central line of the LED element. The first light reflective member 191 is provided to extend so as to cause light emitted from the LED element to have light directivity and to radiate from the LED lighting tube to the outside of the tube. The first light reflective member 191 is integrally provided on a substrate 12.

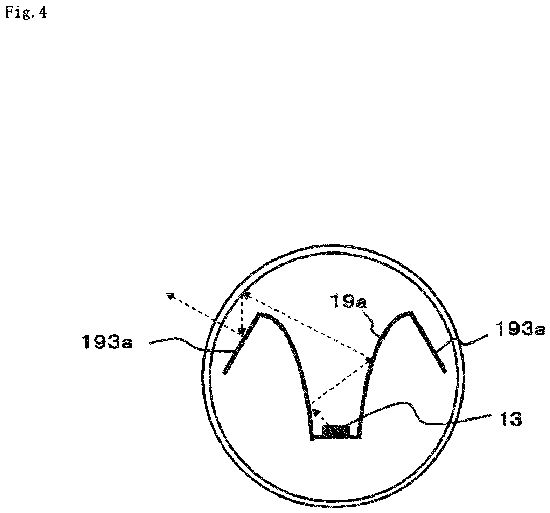

Fig. 4 is a schematic view for explaining an optical path of the light emitted from the light source, which is the LED element in the light-emitting diode type lighting device in Fig. 1. As illustrated in Fig. 4, the first light reflective member is provided on the substrate at an angle of elevation set from 50 degrees to 75 degrees, preferably, 50 degrees to 65 degrees, and the second light reflective member is arranged outward in a wide-angle direction from the end of the first light reflective member along the shape of the total luminous flux transparent plate. Accordingly, the light emitted from the LED element (1) travels in a straight line in the internal space of the first light reflective member from directly below the light source being the LED element and is radiated from the total luminous flux transparent plate to the outside of the tube body, (2) is further reflected on a converging reflective surface of the first light reflective member and travels through the internal space of the first light reflective member to radiate from the total luminous flux transparent plate to the outside of the tube body, and (3) is further reflected on the converging reflective surface of the first reflective member and travels through the internal space of the first light reflective member to reach the total luminous flux transparent plate, and then also reflected on the second light reflective member to radiate from the total luminous flux transparent plate to the outside of the tube body via a light confining means. In addition, the total luminous flux transparent plate preferably has a curved surface.

Here, the light emitted from the LED element is confined in the total luminous flux transparent plate and/or the light confining means provided in a space between the total luminous flux transparent plate and the second light reflective member. The confined light emitted from the LED element is then radiated to the outside of the tube body through the total luminous flux transparent plate. The second light reflective member and/or the total luminous flux transparent plate preferably have/has at least one recessed portion for confining light.

The light radiated from the LED element through a translucent cover including the total luminous flux transparent plate is preferably radiated such that the light has a radiation angle of 120 degrees to 180 degrees and has a total luminous flux of 2000 to 3000 lm.

The first light reflective member has an angle of elevation set from 50 degrees to 75 degrees, and, furthermore, an interval between an arrangement end of the LED element and the first light reflective plate is set to 0.1 to 5.0 mm, a height of the first light reflective plate is five or more times as large as a width of the LED element and is preferably set to 10 mm to 20 mm. Accordingly, the wide radiation angle can reduce a loss in the amount of light to improve illuminance and PPFD. The illuminance radiated from the LED light source is preferably obtained by being multiplied by 1.5 to 2.0. The angle of elevation of the first light reflective member with respect to the substrate, the interval between the end of the LED element and the reflective plate, and the height of the reflective plate may be variable according to the size such as a diameter of the LED lighting device.

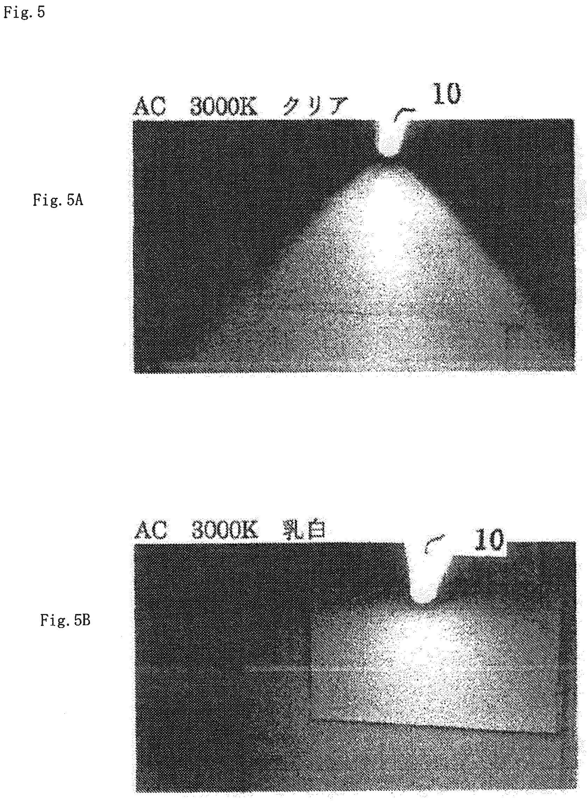

Fig. 5A shows a diagram in which the light emitted from the LED element is radiated via the total luminous flux transparent plate from a state where the light has been confined in the total luminous flux transparent plate, which is the light confining means, and/or the space between the total luminous flux transparent plate and the second light reflective member. Fig. 5B shows a diagram in which the light is radiated from a state of not having been confined. As seen from these diagrams, the light radiated via the total luminous flux transparent plate from the state of having been confined is radiated to the entire total luminous flux transparent plate substantially uniformly.
On the other hand, the light radiated from the state of not having been confined is bright in the substantially central region where the LED element is arranged, and has the illuminance lower in the peripheral region than in the central region. Thus, it can be seen that the illuminance is not uniform between the central region and the peripheral region of the total luminous flux transparent plate.
Here, the total luminous flux transparent plate having a color temperature of 3000 K and a total light transmittance of 60 to 70% (ML 7500 Series manufactured by Teijin Limited; opal cover) is used in Fig. 5A. The total luminous flux transparent plate having a color temperature of 3000 K and a total light transmittance of 89% (MN 4800 Series manufactured by Teijin Chemicals Ltd.; translucent cover, clear plate) is used in Fig. 5B.

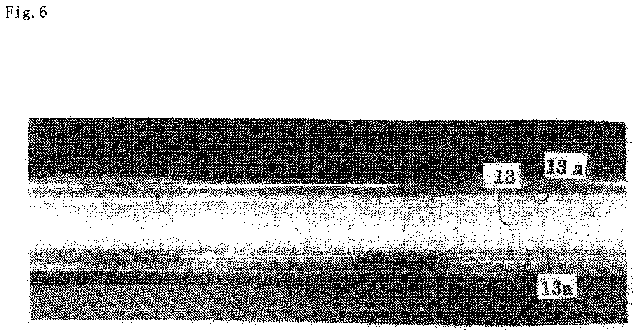

Fig. 6 shows a picture in which a pseudo LED element 13a of an LED element 13 installed on a substrate is reflected on a pseudo LED element forming surface of the first light reflective member when the LED element is seen from a direction of radiation of the light emitted from the LED element arranged on the substrate.
At this time, the LED element preferably has illuminance of 30 to 80 lx/w.

The pseudo LED element forming surface is preferably formed to be defined by the total reflectance of the first light reflective surface, the angle of elevation of the first light reflective member, and the length of the interval between the arrangement end of the LED element and the light reflective surface of the reflective member.

A third light reflective member that connects the first light reflective member and the second light reflective member is preferably provided.

The total luminous flux transparent plate preferably has a total luminous flux transmittance of greater than or equal to 95%.
A total reflectance of the reflective member is preferably defined by greater than or equal to 80%.

The light reflective surface of the first light reflective member according to the present invention includes the light directivity forming surface and the pseudo LED element forming surface preferably having different total reflectances and/or shapes.

At least one of the total reflectance of the light reflective surface, the angle of elevation of the first light reflective member, and the length of the interval between an arrangement end of the LED element and the reflective member is preferably changed to change the number of the pseudo LED elements reflected on the pseudo LED element forming surface to project the pseudo LED element forming surface.

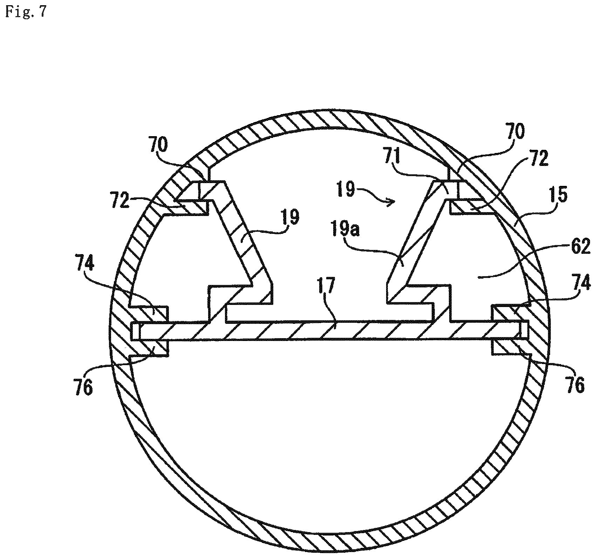

Fig. 7 is a schematic view of a light reflective member 19 attached to a cylindrical tube body. The cylindrical tube body 10 includes a locking portion that locks an upper end portion 71 of the light reflective member 19. The locking portion includes a first locking portion 70 and a second locking portion 72 for locking the upper end portion 71 of the light reflective member 19 in the cylindrical tube body 10. The upper end portion 71 of the light reflective member 19 is sandwiched between the first locking portion 70 and the second locking portion 72. It is sufficient that the upper end portion 71 of the light reflective member 19 is locked by the first locking portion 70. The cylindrical tube body 10 includes a locking portion that locks a substrate support member 17. Both ends of the substrate support member 17 are sandwiched by a third locking portion 74 and a fourth locking portion 76. It is sufficient that the substrate support member 17 is locked by the fourth locking portion. The substrate support member 17 and the light reflective member 19 are integrally formed. Light confined in a light reflective portion light confining space 62 is preferably radiated from a total luminous flux transparent plate 31 to the outside of the tube body. The light reflective member 19 the substrate support member 17 may be formed separately. The light reflective member 19 and the substrate support member 17 are fixed together with screws or an adhesive. The light reflective member 19 including the substrate support member 17 may be detachably attached to the locking portion. The light reflective member 19 and the substrate support member 17 may be separately detachably attached to the locking portion.

Furthermore, a light directivity forming surface and the pseudo LED element forming surface preferably have different shapes. The light directivity forming surface and the pseudo LED element forming surface may have at least a part of shape formed by a straight line and a shape other than the straight line, such as a curved surface, irregularities, and a shape of a saw, and further formed by a combination of these shapes, a combination of these shapes having variable pitches, or the like. The light directivity forming surface and the pseudo LED element forming surface may have the same shape.

Furthermore, the light directivity forming surface and the pseudo LED element forming surface may have different total reflectances.
They may have the different total reflectances within a range from 80% to 95%.

The first light reflective member includes the light directivity forming surface and the pseudo LED element forming surface. The light directivity forming surface causes the light emitted from the LED element to have directivity and to radiate from the LED lighting tube to the outside of the tube. The pseudo LED element forming surface reflects the pseudo LED element of the installed LED element on the converging reflective surface facing the LED element. The pseudo LED element forming surface may form the light directivity forming surface.

In a straight-tube light-emitting diode type lighting lamp, the light-emitting diode type lighting device has a length and a diameter so as to substitute for a conventional fluorescent tube in a fluorescent lamp fixture. The straight-tube light-emitting diode type lighting lamp has the same length as that of the conventional straight-tube fluorescent lamp. The length may be appropriately set to, for example, 300 mm to 2400 mm according to its use. The straight-tube light-emitting diode type lighting lamp has almost the same diameter as that of the conventional straight-tube fluorescent lamp, and preferably has substantially the same external shape and exterior appearance as a whole as those of the straight-tube fluorescent lamp.

The tube body of the light-emitting diode type lighting device is a member having a substantially semi-cylindrical cross-sectional shape. For example, the tube body of the light-emitting diode type lighting device may be made of a material such as glass and synthetic resin. For example, the tube body may be a member integrally formed to be a long semicylinder made of a material having predetermined elasticity such as polycarbonate resin. The whole or a part of the tube body of the light-emitting diode type lighting lamp has translucency, and may be made of a transparent, translucent, or colored transparent material as long as it allows light to pass therethrough.

An electronic part such as an AC power source for driving the light-emitting diode type lighting device is provided in the LED lighting tube, and is preferably installed on the substrate in a position and a wiring manner that do not interfere with the light emitted from the LED light source.

The LED element emits the illuminance that allows the pseudo LED element in the LED lighting device of the present invention to be reflected, and preferably has the illuminance of at least 30 lx/w to 80 lx/w. Here, the LED illuminance is measured by applying an alternating current of 100 V 50 Hz to the light-emitting diode type lighting device. A general AA-grade luminometer prescribed by JIS C1609 is used for the measurement. A measurement distance is 1 m between a front surface of the light source, which is the LED element, and a measurement reference surface of the illuminance shape. The light source turns on downward in a vertical direction for the measurement. Measurement results are as follows. Power consumption (W) of the LED element is 19.5 W.
Measurement result 1; 724 (lx) 37.1 1x/w
Measurement result 1; 870 (lx) 44.6 lx/w
Measurement result 1; 1556 (lx) 79.8 1x/w

The power source that is a driving device for driving the LED element as the light source is preferably driven by (1) any single power source of 5 V, 12 V, and 24 V, (2) a forward voltage of at least 1.5 V to 4.5 V, or (3) any voltage of 90 V to 240 V.

The power source is preferably arranged in a position that does not interfere with the light emitted from the LED element. The power source that drives the LED element is arranged on the bottom of the tube body below the substrate on which the LED element is mounted. The power source that drives the LED element is mounted on the substrate opposite to the first light reflective member facing the LED element.

The LED element is a surface-mounting white LED that emits white light through the application of the predetermined voltage described above. The LED element is preferably disposed in a central position in a width direction on the surface side of the substrate at a predetermined interval in a row along the longitudinal direction of a substrate 12. The LED element may be disposed in a plurality of rows along the longitudinal direction of the substrate 12.

The reflective member preferably includes a heat sink member of an Al material, for example. In the straight-tube light-emitting diode type lighting lamp of this embodiment, a distance between a heat sink portion immediately below the substrate on which the LED element is installed and a heat sink portion touched by a human body is two to three or more times as large as that of a conventional heat sink. This improves an efficiency of heat conductivity and an effect of heat radiation of heat generated when the LED element is energized.

In this embodiment, it is preferable that the heat sink structure immediately below the substrate on which the LED element is installed is semi-cylindrical and has an M-shaped structure. The M-shaped structure has a long distance, instead of a short distance, between the heat sink immediately below the LED element and the heat sink touched by a human body. This improves the efficiency of heat conductivity to further promote heat radiation.

In this embodiment, the M-shaped heat sink (cross-sectional) structure that collects and reflects light at a fixed angle causes the light emitted from the LED element to be reflected and directed toward a predetermined direction, and aims to improve illuminance. The heat sink surface on the LED element side is preferably subjected to silver coating, plating, or chroming that has high reflection efficiency to increase an angle of light distribution of the heat sink having the M-shaped structure (in cross section). Similarly, a heat sink cover is preferably designed for diffusion or is preferably a prism type to increase the angle of light distribution.

The present invention is not limited to the above-described embodiment. In other words, the structural components in the above embodiment can be modified, combined, and replaced by a person skilled in the art within the technical scope or the equal scope of the present invention.

A light-emitting diode type lighting device 1 has a length and a diameter so as to substitute for a conventional fluorescent lighting tube in a fluorescent lamp fixture. The light-emitting diode type lighting device has the same length as that of the conventional straight-tube fluorescent lamp. The length may be appropriately set to, for example, 300 mm, 450 mm, 600 mm, 900 mm, 1200 mm, 1800 mm, or 2400 mm according to its use. The light-emitting diode type lighting device has almost the same tube diameter as that of the conventional straight-tube fluorescent lamp, and preferably has substantially the same external shape and exterior appearance as a whole as those of the straight-tube fluorescent lamp.

As illustrated in Fig. 3, the light-emitting diode type lighting device 1 includes the cylindrical tube body that includes a translucent cover 31 that the total luminous flux transparent plate and a tube body member, the LED element 13 as a light source arranged in the cylindrical tube body 10, the substrate 12 on which the LED element 13 is installed, the substrate support member 17, the light reflective member 19, an LED controller 22, and end caps 50.. The light reflective member 19 includes the first light reflective member 191, a second light reflective member 193, and a third light reflective member 195. Here, the tube body member 15, the substrate support member 17, the first light reflective member 191, the second light reflective member 193, and the third light reflective member 195 are preferably made of a heat sink member of aluminum, copper, or plastic, for example. In this embodiment, the substrate support body member 17 and the first light reflective member 191 are preferably formed integrally. The first light reflective member 191, the second light reflective member 193, and the third light reflective member 195 are preferably formed integrally. Further, the substrate support member 17, the first light reflective member 191, the second light reflective member 193, and the third light reflective member 195 are preferably formed integrally. These members 17, 191, 193, 195 can be easily formed integrally if plastic is used for them. The substrate support member 17, the first light reflective member 191, the second light reflective member 193, and the third light reflective member 195 may be separately formed, and then, these members may be selected to be bonded together with an adhesive, screws, or the like.

These members 15, 17, 191, 193, 195 can obtain a high effect of heat radiation with the heat sink. For example, if a material for the heat sink is aluminum, heat in the portion touched by a human body can be made at a safe temperature, for example, 40°C. A material for the heat sink is typically aluminum or copper that has excellent efficiency of heat conductivity.

These members 17, 191, 193, 195 are integrally processed by drawing (extruding) with an anodized mold, which can thus make manufacturing steps simple and reduce costs and steps.

In other words, in the light-emitting diode type lighting device 1, a temperature of the heat sink surface can be a temperature (approximately 40°C) safely touched by a human body, which has been the biggest challenge of LED straight tubes (fluorescent lamp type) and LEDs. Also, in the light-emitting diode type lighting device 1, the illuminance can exert equal or more than equal performance to that of a fluorescent lamp.

As illustrated in Fig. 3, the substrate 12 is housed in the longitudinal internal space (confined space) of the substrate support member 17 and supported by the substrate support member 17. The LED element 13 is arranged in a stripe-shaped opening formed on the translucent cover 31 side of the substrate support member 17 such that its light-emitting surface faces the translucent cover 31.

The substrate 12 preferably has conductivity. The substrate support member 17 receives the heat generated by the LED element via the substrate 12, and the heat is transmitted to the first light reflective member.
The first light reflective member 191 is arranged to extend from one end, which is a joint portion with the substrate support member 17, to the translucent cover 31.

As illustrated in Fig. 3, in the horizontal cross-sectional view of the confined space of the light-emitting diode type lighting device 1, the LED element 13 is arranged on a central line 61 of the translucent cover 31 along the horizontal cross-sectional view. The translucent cover 31 is preferably a total luminous flux transparent plate having a total luminous flux transmittance of greater than or equal to 95%. The total luminous flux transparent plate preferably has a total luminous flux transmittance of greater than or equal to 95 (%). ML Series of a high-diffusion type, which is made of resin and manufactured by Teijin Limited, is used as the translucent cover 31. Here, the total luminous flux transmittance (%) is expressed by a total luminous flux × 100 when a test specimen is placed/a total luminous flux × 100 when the test specimen is not placed.

The LED element 13 installed on the substrate 12 may be arranged in one row or a plurality of rows with a predetermined interval in the longitudinal direction of the substrate. As illustrated in Fig. 2, the plurality of LED elements 13 are installed on the substrate 12 at equal intervals along the longitudinal direction. The LED controller 21 is arranged at the end portion of the substrate 12.

The first light reflective member 191 is arranged at both sides of the LED element symmetrically or asymmetrically with respect to the central line of the LED element with an interval (S) between the LED element and the first light reflective member 191. The first light reflective member 191 is provided to extend so as to cause the light emitted from the LED element to have light directivity and to radiate from the LED lighting tube to the outside of the tube. The length of the first light reflective member is five or more times as large as a width of the LED element and is preferably set to approximately 10 mm to 20 mm from the substrate.

Here, the first light reflective member 191 preferably includes a converging reflective surface 19a on the LED element side. The converging reflective surface 19a preferably includes a light directivity forming surface 20a and a pseudo LED element forming surface 20b that reflects the pseudo LED element of the installed LED element on the light reflective surface on the side facing the LED element.

A length of an interval (S) between the end portion of the LED element and the converging reflective surface of the first reflective member 191 is defined by 0.1 mm to 5.0 mm, preferably, 0.5 mm to 2.0 mm. An angle of elevation α of the first light reflective member 191 is defined by 50 degrees to 75 degrees, preferably, 50 degrees to 65 degrees. A total reflectance of the reflective member is preferably defined by greater than or equal to 80%. The above-mentioned interval may be zero if an electrical insulating member is provided on a part of the converging reflective surface.

The pseudo LED element of the LED element installed on the substrate is reflected on the converging reflective surface 19a of the first light reflective member 191. Fig. 6 illustrates a diagram of the pseudo LED element reflected on the converging reflective surface 19a of the first light reflective member 191 when seen from below the LED element installed on the substrate from the radiation direction of the LED element.

The end caps 50 are inserted at two end portions of the tubular structure formed by the tube body member 15 and the transparent cover 31. The end caps 50 each include a power source pin 51.

The first light reflective member 191 includes the converging reflective surface 19a on an extending portion 23 that extends toward the translucent cover 31 in a direction in which the light emitted from the LED element installed on the substrate travels. The extending portion 23 is arranged at both sides of the LED element symmetrically or asymmetrically with respect to the central line of the LED element in the direction in which the light emitted from the LED element installed on the substrate travels. The extending portion 23 is preferably disposed in such a position that directs the light from the light-emitting element 13 toward the translucent cover 31.

The first light reflective member 191 includes the first light reflective member 191, the second light reflective member 193, and the third light reflective member 195. The first light reflective member 191 extends toward the translucent cover 31 at an angle of elevation, which falls within a range of 50 degrees to 75 degrees. The second light reflective member 193 is bent along the curved shape of the translucent cover 31. The third light reflective member 195 connects the first light reflective member 191 and the second light reflective member 193. The configuration of the light reflective member 19 is not limited to the configuration of the first light reflective member 191, the second light reflective member 193, and the third light reflective member 195. The light reflective member 19 may have a multistage configuration that includes more light reflective members connected together.

The second light reflective member 193 and the third light reflective member 195 respectively and preferably include a light reflective surface 193a and a light reflective surface 195a having light reflective characteristics on the side facing the translucent cover 31.

The pseudo LED element forming surface is preferably formed to be defined by at least one of the total reflectance of the light reflective surface, the angle of elevation of the first light reflective member, and the length of the interval between the arrangement end of the LED element and the light reflective surface of the light reflective member.

The total luminous flux transparent plate preferably has a total luminous flux transmittance of greater than or equal to 95%. A total reflectance of the reflective member is preferably defined by greater than or equal to 80%.

In other words, the total reflectance of the converging reflective surface of the first light reflective member is preferably greater than or equal to 80% to direct the light-emitting illuminance of the LED element to equal or more than equal to that of the conventional fluorescent lamp. Specifically, the converging reflective surface 19a is preferably subjected to silver plating, silver coating, or chrome plating, for example. At this time, the illuminance is determined based on the theorem of brightness of light that "brightness is inversely proportional to the square of a distance from a light source to a radiation surface".

The light emitted from the LED element is radiated to the outside of the tube body through the total luminous flux transparent plate 31 via the light reflective member 19. When being radiated to the outside of the tube body through the total luminous flux transparent plate 31 via the first light reflective member 191, the light emitted from the LED element is confined in the total luminous flux transparent plate 31 arranged with respect to the light reflective surface 193a of the second light reflective member 193 and/or is confined in a light confining path 60 formed between the total luminous flux transparent plate 31 and the second light reflective member 193. Then, the light is confined in the light confining space 62 provided in the light confining path 60. The confined light is preferably radiated from the total luminous flux transparent plate 31 to the outside of the tube body. In addition, the light emitted from the LED element is confined in the light confining space 62 through the light reflective member, preferably, the first light reflective member 191. Then, the confined light is preferably radiated from the total luminous flux transparent plate 31 to the outside of the tube body.

Furthermore, when the light emitted from the LED element is radiated to the outside of the tube body through the total luminous flux transparent plate via the first light reflective member 191, the angle of elevation of the first light reflective member 191 with respect to the substrate is set to 50 degrees to 75 degrees, preferably, 50 degrees to 65 degrees; the interval (S) between the end portion of the LED element and the first light reflective member is set to 0.5 to 5.0 mm; and a height of the reflective plate is five or more times as large as a width of the LED element and is preferably set to 10 to 20 mm. With these settings, the light is confined in the total luminous flux transparent plate 31 arranged with respect to the reflective surface of the second light reflective member 193 and/or is confined in the light confining path 60 formed between the total luminous flux transparent plate and the second light reflective member. The confined light is preferably radiated from the total luminous flux transparent plate 31 to the outside of the tube body.

The light confining path 60 formed in the space between the total luminous flux transparent plate and the second light reflective member is preferably formed such that the end portion of the second light reflective member is engaged in the total luminous flux transparent plate.

The second light reflective member and/or the total luminous flux transparent plate preferably have/has at least one recessed portion 62 for confining light.

Thus, the light radiated from the LED element to the outside of the tube via the total luminous flux transparent plate is radiated such that the light has a radiation angle of 120 degrees to 180 degrees and has a total luminous flux of 2000 to 3000 lm. At this time, the pseudo LED is preferably reflected on the first light reflective member.

The light reflective surface 193a of the second light reflective member 193 has light reflective characteristics, which allows the light from the LED element to be reflected on the inner surface of the translucent cover 31 as illustrated in Fig. 4 and to pass through the translucent cover 31.

Silver coating, silver plating, or equivalent coating is the processing for increasing reflection efficiency of this embodiment. Silver coating can improve the total reflectance to 90%.

In the light-emitting diode type lighting device 1, a distance from the LED element and the outer peripheral surface (portion touched by a human body) of the light-emitting diode type lighting device 1 can be increased greater than (can be increased twice as long as) that of the conventional structure with the light reflective member having the shape illustrated in Fig. 2 and Fig. 3.

The straight-tube light-emitting diode type lighting device 1 can increase an angle (greater than or equal to 140 degrees) of illuminance distribution, can have the performance (illuminance and light distribution) of the conventional fluorescent lamp while reducing power consumption of the fluorescent lamp by 50%, and can save energy of a light source of lighting. Specifically, the power consumption can be approximately 12 to 13 in comparison with the fluorescent lamp, and illuminance and PPFD can be two to three times (as great as those of the conventional LED). The straight-tube light-emitting diode type lighting device 1 does not emit high heat like the fluorescent tube and contributes to safety and security. The straight-tube light-emitting diode type lighting lamp 1 can be reduced to less than or equal to 500 g.
Hereinafter, another embodiment of the shape of the converging reflective surface of the first light reflective member is described.

### Second Embodiment

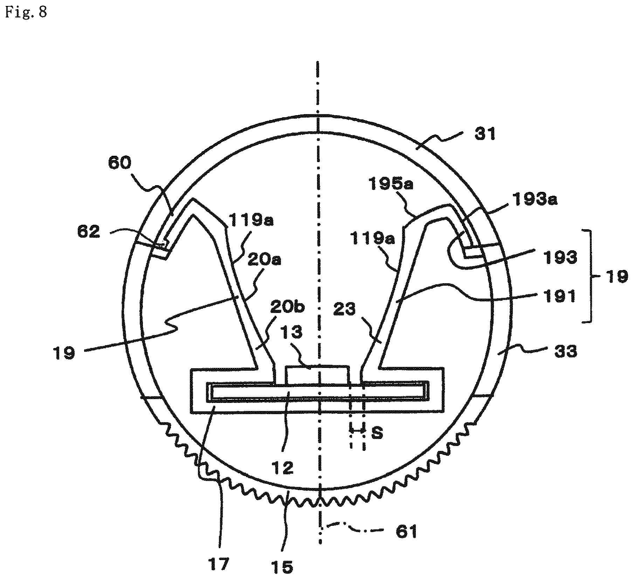

Fig. 8 is a sectional view of a straight-tube light-emitting diode type lighting device of this embodiment taken along an A-A section line illustrated in Fig. 1. As illustrated in the drawing, in this embodiment, a converging reflective surface 119a on the LED element side of the first light reflective member 191 forming the light reflective member 19 has light reflective characteristics and a concave curved surface with respect to the central line 61. A curvature of the curved surface is appropriately set according to required light characteristics. The converging reflective surface 19a may be formed to have a curved surface that is convex toward the central line 61. A curvature of the curved surface is appropriately set according to required light directivity.

### Third Embodiment

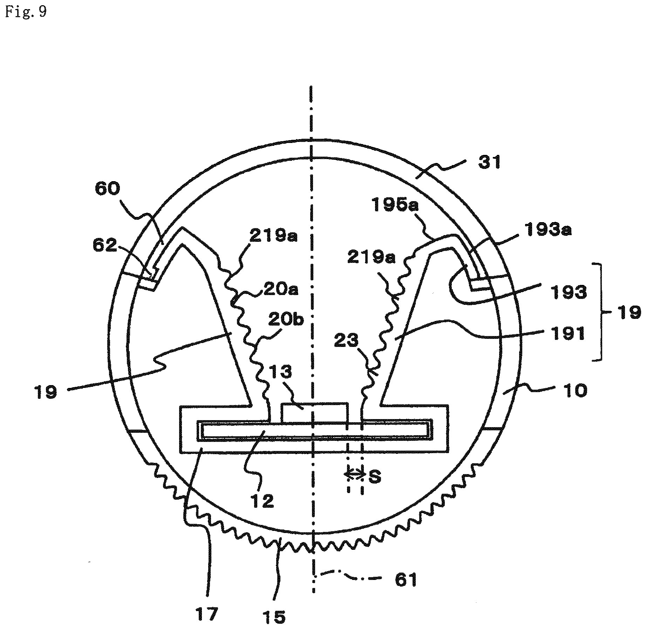

Fig. 9 is a sectional view of a light-emitting diode type lighting device of this embodiment taken along the A-A section line illustrated in Fig. 1.
As illustrated in the drawing, in this embodiment, the whole or a part of a converging reflective surface 219a on the LED element 13 side of the first light reflective member 191 has light reflective characteristics and has many irregularities formed thereon. It is preferable that a shape, size, interval, and the number of the irregularities are appropriately set according to required light characteristics.

### Fourth Embodiment

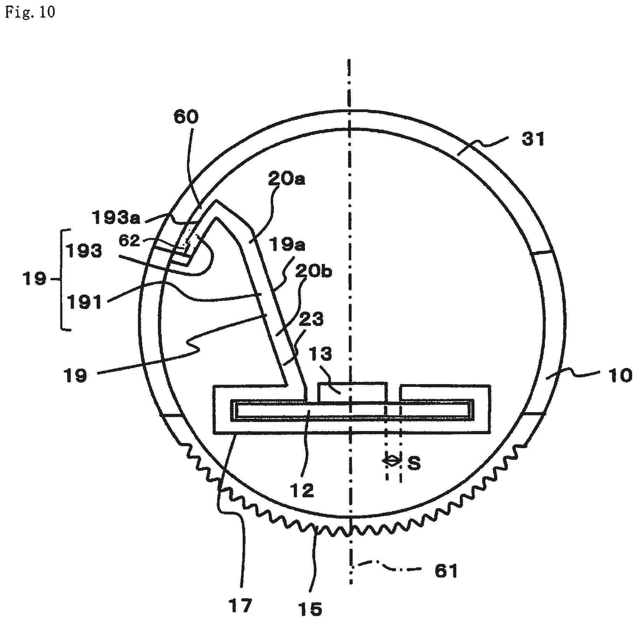

Fig. 10 is a cross section of a straight-tube light-emitting diode type lighting device of this embodiment taken along the A-A section line illustrated in Fig. 1.
As illustrated in the drawing, in this embodiment, the converging reflective surface 19a on the LED element 13 side of the first light reflective member 191 is formed on only one side with respect to the central line 61.
The light-emitting diode type lighting device of this embodiment is disposed at the end portion when the plurality of light-emitting diode type lighting lamps are aligned in parallel. In this embodiment, the amount of light can be increased in one direction.

### Fifth Embodiment

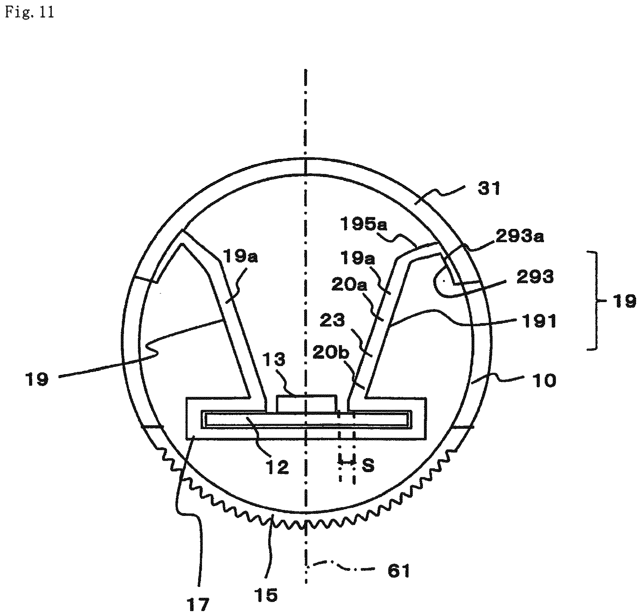

Fig. 11 is a cross section of a light-emitting diode type lighting device of this embodiment taken along the A-A section line illustrated in Fig. 1.
In the first embodiment described above, it is illustrated that a space is formed between a light reflective surface 293a of a second light reflective member 293, which faces the translucent cover 31, of the first light reflective member 191 and the translucent cover 31. In this embodiment, as illustrated in the drawing, the light reflective surface 293a of the second light reflective member 293 may be provided in contact with the inner surface of the translucent cover 31. This configuration can effectively suppress the entry of water from a mounting portion bonded when the tube body member 33 and the translucent cover 31 are mounted. This configuration allows the light-emitting diode type lighting device to be used as an outdoor lamp.

### Sixth Embodiment

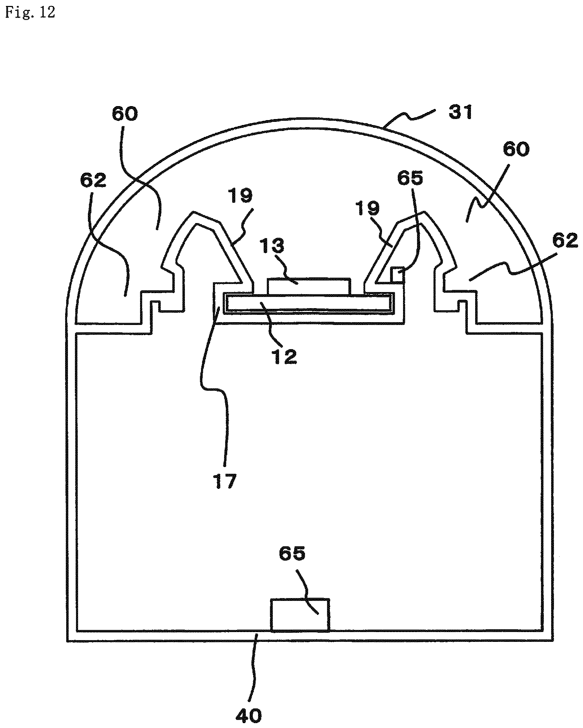

Fig. 12 is basically the same as the configuration of the LED lighting device 1 in Fig. 3. In the drawing, a frame member 40 for creating a space in which the power source 65 of the light-emitting diode 13 is housed is provided.

The driving device including the power source is preferably arranged in a position that does not interfere with the light emitted from the LED light source. For example, the power source 65 is located on a bottom portion of the frame member 40. The power source 50 may be disposed on the base portion in the space of the angle of elevation α of the light reflective member 191.

Here, it is preferable that a forward voltage of at least 1.5 V to 4.5 V for driving the LED element of the light-emitting diode type lighting device is applied to the LED element to drive the light-emitting diode type lighting device.

Here, upon the application to the LED element, a current starts to flow at greater than or equal to a predetermined voltage. The voltage is referred to as the forward voltage. Brightness of the light emitted from the LED element is proportional to the current.
A voltage between an anode and a cathode at this time is the forward voltage.

Here, the forward voltage of one chip of the LED element that emits white light is, for example, 1.8 V to 2.3 V, 2.4 V to 3.3 V, 2.8 V to 3.2 V, 3.2 V to 3.6 V, or 3.6 V to 4.03 V.

A universal power source is used in the LED lighting device of this example. A hundred of LED elements (chips) are connected to each other. An input voltage (AC) of AC type is 20 W, 90 V to 264 Vac. A battery used for the power source allows driving. The LED lighting device can be driven by a single power source of 5 V, for example. n batteries × 1.5 V can be used as the driving power source. Even if the power source is used, the light directivity forming surface 20b and the pseudo LED element forming surface 20a can be provided. The light directivity forming surface 20b causes the light emitted from the LED element to have directivity and to radiate from the LED lighting tube to the outside of the tube. The pseudo LED element forming surface 20a reflects the pseudo LED element of the installed LED element on the converging reflective surface on the side facing the LED element.

It is preferable that the driving device such as the AC power source is provided in the LED lighting tube and arranged in a position that does not interfere with the light radiated from the LED light source. The whole or a part of the electronic part such as the power source other than the LED light source may be disposed on the back surface side of the substrate instead of the front surface side. If the whole or a part of the electronic part is provided on the front surface side of the substrate 12, the substrate can be installed closer to the back side in the LED lighting device and the internal space on the front surface side of the substrate can thus be increased.

The driving device such as the AC power source is preferably arranged below the substrate on which the LED element is installed in the LED lighting tube or arranged on the back side of the converging reflective surface of the reflective member.

Here, a forward voltage of at least 1.5 V to 4.5 V for driving the LED element of the light-emitting diode type lighting device is applied to the LED element to drive the light-emitting diode type lighting device. The pseudo LED element is reflected on the pseudo LED element forming surface when the LED element method installed on the substrate is seen from the direction in which the light is emitted from the LED element installed on the substrate. The pseudo LED element is preferably reflected on the pseudo LED element forming surface when the LED element emits light. The driving voltage is preferably driven by a single power source.

### Seventh Embodiment

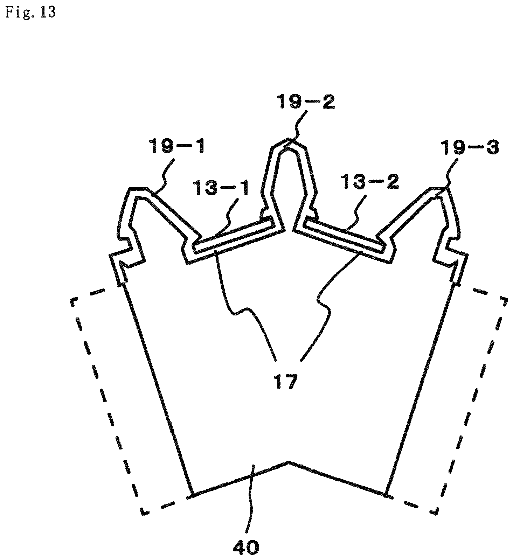

In Fig. 13, two light-emitting diodes 13-1, 13-2 may be provided in a direction orthogonal to the longitudinal direction. The number of light-emitting diodes 13 provided in the direction orthogonal to the longitudinal direction may be three or more. The light-emitting diode 13-1 is sandwiched by a light reflective member 19-1 and a light reflective member 19-2 and has reflective characteristics on the light-emitting diode side of the light reflective member 19-1 and the light reflective member 19-2. The light-emitting diode 13-2 is sandwiched by the light reflective member 19-2 and a light reflective member 19-3 and has reflective characteristics on the light-emitting diode side of the light reflective member 19-2 and the light reflective member 19-3. The two light-emitting diodes 13-1, 13-2 are each provided to be inclined so as to emit light in a different direction toward the outside of the lighting device.

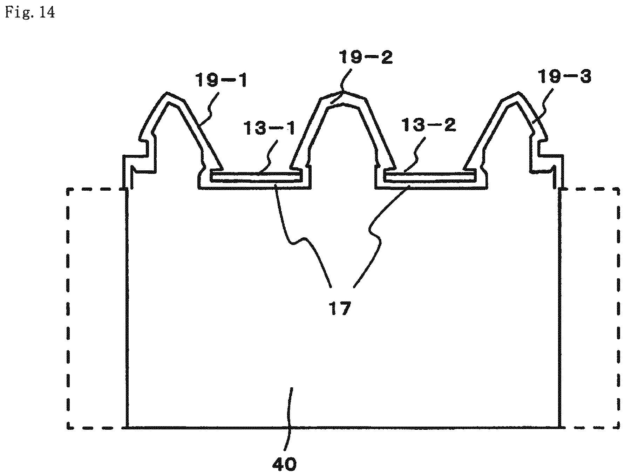

As illustrated in Fig. 14, the two light-emitting diodes 13-1, 13-2 may be provided in the direction orthogonal to the longitudinal direction. The number of light-emitting diodes 13 provided in the direction orthogonal to the longitudinal direction may be three or more. The light-emitting diode 13-1 is sandwiched by the light reflective member 19-1 and the light reflective member 19-2 and has reflective characteristics on the light-emitting diode side of the light reflective member 19-1 and the light reflective member 19-2. The light-emitting diode 13-2 is sandwiched by the light reflective member 19-2 and the light reflective member 19-3 and has reflective characteristics on the light-emitting diode side of the light reflective member 19-2 and the light reflective member 19-3.

The light-emitting diode type lighting device according to the present invention is preferably a straight-tube light-emitting diode type lighting device.
The light-emitting diode type lighting device according to the present invention may be used as a light source of an electronic device, for example, a backlight of a liquid crystal device.

### Industrial Applicability

The present invention is applicable to a light-emitting diode type lighting lamp, an electronic device, a plant factory, and an LED sign.

### Reference Sign List

- 1: Light-emitting diode type lighting device
- 10: Cylindrical tube body
- 12: Substrate
- 13: LED element
- 13a: Pseudo LED element
- 15: Tube body member
- 61: Central line
- 17: Substrate support member
- 19: Light reflective member
- 191: First light reflective member
- 19a: Converging reflective surface
- 193: Second light reflective member
- 193a: Light reflective surface
- 195: Third light reflective member
- 195a: Light reflective surface
- 20a: Light directivity forming surface
- 20b: Pseudo LED element forming surface
- 23: Extending portion of first light reflective member
- 31: Translucent cover
- 50: End cap
- 60: Light confining path
- 62: Light confining recessed portion
- 65: Power source
- 70: First locking portion
- 72: Second locking portion
- 74: Third locking portion
- 76: Fourth locking portion

## Claims

1. A light-emitting diode type lighting device, comprising:
an LED lighting tube that includes a total luminous flux transparent plate arranged in a light radiation direction;
an LED element disposed on a substrate in the LED lighting tube so as to face the total luminous flux transparent plate; and
a light reflective member including a converging reflective surface that is arranged on a side from which the LED element emits light and has light reflective characteristics, wherein
the light reflective member is arranged so as to extend in the light radiation direction symmetrically or asymmetrically with respect to a central line of the LED element, and
the converging reflective surface of the light reflective member includes
a light directivity forming surface that causes light emitted from the LED element to have light directivity and to radiate from the LED lighting tube to the outside of the tube through the total luminous flux transparent plate, and
a light confining means for confining the light emitted from the LED element in the total luminous flux transparent plate and/or a space between the total luminous flux transparent plate and the light reflective member, the light then being radiated to the outside of the tube through the total luminous flux transparent plate.

2. A light-emitting diode type lighting device, comprising:
an LED lighting tube that includes a total luminous flux transparent plate arranged in a light radiation direction;
an LED element disposed on a substrate in the LED lighting tube so as to face the total luminous flux transparent plate; and
a light reflective member including a converging reflective surface that is arranged on a side from which the LED element emits light and has light reflective characteristics, wherein
the light reflective member is arranged so as to extend in the light radiation direction symmetrically or asymmetrically with respect to a central line of the LED element,
the converging reflective surface of the light reflective member includes
a light directivity forming surface that causes light emitted from the LED element to have light directivity and to radiate from the LED lighting tube to the outside of the tube through the total luminous flux transparent plate, and
a pseudo LED element forming surface that reflects a pseudo LED element of the LED element, and
the pseudo LED element of the LED element arranged on the substrate is reflected on the pseudo LED element forming surface when the LED element is seen from a direction of the light radiated from the LED element arranged on the substrate.

3. A light-emitting diode type lighting device, comprising:
an LED lighting tube that includes a total luminous flux transparent plate arranged in a light radiation direction;
an LED element disposed on a substrate in the LED lighting tube so as to face the total luminous flux transparent plate; and
a light reflective member including a converging reflective surface that is arranged on a side from which the LED element emits light and has light reflective characteristics, wherein
the light reflective member includes a first light reflective member and a second light reflective member,
the first light reflective member includes the converging reflective surface that is arranged on the side from which the LED element emits light and has the light reflective characteristics,
the first light reflective member is arranged so as to extend in the light radiation direction symmetrically or asymmetrically with respect to a central line of the LED element,
the converging reflective surface of the first light reflective member includes
a light directivity forming surface that causes light emitted from the LED element to have light directivity and to radiate from the LED lighting tube to the outside of the tube through the total luminous flux transparent plate, and
a pseudo LED element forming surface that reflects a pseudo LED element of the LED element, and
the second light reflective member including a converging reflective surface reflective surface that is arranged to face the total luminous flux transparent plate in the lighting tube and has light reflective characteristics is provided,
the second light reflective portion is arranged outward in a wide-angle direction from the end of the first reflective member along the shape of the total luminous flux transparent plate,
the second light reflective member includes a light confining means for confining the light emitted from the LED element in the total luminous flux transparent plate and/or a space between the total luminous flux transparent plate and the light reflective member, the light then being radiated to the outside of the tube through the total luminous flux transparent plate, and
the pseudo LED element installed on the substrate is reflected on the pseudo LED element forming surface when the light is radiated to the outside of the lighting tube.

4. A light-emitting diode type lighting device, comprising:
an LED lighting tube that includes a total luminous flux transparent plate arranged in a light radiation direction;
an LED element disposed on a substrate in the LED lighting tube so as to face the total luminous flux transparent plate; and
a light reflective member including a converging reflective surface that is arranged on a side from which the LED element emits light and has light reflective characteristics, wherein
the light reflective member includes a first light reflective member and a second light reflective member,
the first light reflective member includes the converging reflective surface that is arranged on the side from which the LED element emits light and has the light reflective characteristics,
the first light reflective member is arranged so as to extend in the light radiation direction symmetrically or asymmetrically with respect to a central line of the LED element,
the converging reflective surface of the first light reflective member includes
a light directivity forming surface that causes light emitted from the LED element to have light directivity and to radiate from the LED lighting tube to the outside of the tube through the total luminous flux transparent plate, and
a pseudo LED element forming surface that reflects a pseudo LED element of the LED element, and
the second reflective member including a converging reflective surface that is arranged to face the total luminous flux transparent plate in the lighting tube and has light reflective characteristics is provided,
the second reflective member is arranged outward in a wide-angle direction from the end of the first reflective member along the shape of the total luminous flux transparent plate,
the second light reflective member includes a light confining means for confining the light emitted from the LED element in the total luminous flux transparent plate and/or a space between the total luminous flux transparent plate and the reflective member, the light then being radiated to the outside of the tube through the total luminous flux transparent plate, and
the pseudo LED element of the LED element arranged on the substrate is reflected on the pseudo LED element forming surface when the LED element is seen from a direction of the light radiated from the LED element arranged on the substrate.

5. The light-emitting diode type lighting device according to any one of claims 1 to 4, wherein the light-emitting diode type lighting device is arranged in a position that does not interfere with the light emitted from the LED element.

6. The light-emitting diode type lighting device according to any one of claims 1 to 5, wherein a cylindrical tube body that includes a locking portion for locking the light reflective member is provided.

7. The light-emitting diode type lighting device according to any one of claims 1 to 5, wherein the light reflective member is made of a resin member.

8. The light-emitting diode type lighting device according to claim 3 or 4, wherein a third light reflective member that connects the first light reflective member and the second light reflective member is provided.

9. The light-emitting diode type lighting device according to claim 3 or 4, wherein the pseudo LED element forming surface is formed to be defined by a total reflectance of the first reflective member, an angle of elevation of the first reflective member, and an interval between an arrangement end of the LED element and the first reflective member.

10. The light-emitting diode type lighting device according to claim 3 or 4, wherein the first light reflective member has an angle of elevation set from 50 degrees to 75 degrees with respect to the substrate.

11. The light-emitting diode type lighting device according to claim 3 or 4, wherein a length of an interval between an arrangement end of the LED element and the converging reflective surface of the light reflective member is set from 0.1 mm to 5.0 mm, an angle of elevation of the substrate surface is set from 50 degrees to 75 degrees, and a height of the first light reflective member is five or more times as large as a width of the LED element and is preferably set to 10 mm to 20 mm.

12. The light-emitting diode type lighting device according to claim 3 or 4, wherein at least one of a total reflectance of the light reflective surface, an angle of elevation of the first light reflective member, and a length of an interval between an arrangement end of the LED element and the converging reflective surface of the reflective member is changed to change the number of the pseudo LED elements reflected on the pseudo LED element forming surface to project the pseudo LED element forming surface.

13. The light-emitting diode type lighting device according to claim 3 or 4, wherein the second reflective member and/or the total luminous flux transparent plate have/has a recessed portion for confining light.

14. The light-emitting diode type lighting device according to claim 3 or 4, wherein the total luminous flux transparent plate has a total total luminous flux transparent plate of greater than or equal to 95%.

15. The light-emitting diode type lighting device according to claim 3 or 4, wherein a total reflectance of the light reflective member is defined by greater than or equal to 80%.

16. The light-emitting diode type lighting device according to claim 3 or 4, wherein the light reflective surface of the first light reflective member includes the light directivity forming surface and the pseudo LED element forming surface having different total reflectances and/or shapes.

17. The light-emitting diode type lighting device according to any one of claims 1 to 4, wherein the second light reflective member includes a heat sink.

18. The light-emitting diode type lighting device according to any one of claims 1 to 4, wherein the light-emitting diode type lighting device is a straight-tube light-emitting diode type lighting device.

19. An electronic device, comprising the light-emitting diode type lighting device according to any one of claims 1 to 18.

20. A plant factory, comprising the light-emitting diode type lighting device according to any one of claims 1 to 18.

21. An LED sign, comprising the light-emitting diode type lighting device according to any one of claims 1 to 18.
